Europäisches Patentamt

European Patent Office

Office européen des brevets

(11) Numéro de publication: **0 249 538**
**A1**

## (12) DEMANDE DE BREVET EUROPEEN

(21) Numéro de dépôt: **87401260.2**

(22) Date de dépôt: **04.06.87**

(51) Int. Cl.4: **H 03 M 1/36**

(30) Priorité: **10.06.86 FR 8608409**

(43) Date de publication de la demande:
**16.12.87 Bulletin 87/51**

(84) Etats contractants désignés: **DE GB NL**

(71) Demandeur: **THOMSON-CSF**
**173, Boulevard Haussmann**
**F-75379 Paris Cédex 08 (FR)**

(72) Inventeur: **Tung, Pham Ngu**
**THOMSON-CSF SCPI 19, avenue de Messine**
**F-75008 Paris (FR)**

(74) Mandataire: **Taboureau, James et al**
**THOMSON-CSF SCPI 19, avenue de Messine**
**F-75008 Paris (FR)**

(54) Encodeur analogique-numérique.

(57) L'invention concerne un encodeur analogique-numérique qui donne d'un signal électrique analogique un nombre codé binaire.

Un encodeur comprend un premier étage de comparateurs (1 à 15) qui "pèsent" le signal analogique d'entrée, et au moins deux étages de portes OU-NON (101 à 121) (141 à 143) qui le transforment en un nombre à N bits. Selon l'invention, le second étage est divisé en groupes de portes (101 à 107) (111 à 113) (121) qui travaillent en parallèle. Chaque groupe de portes élabore l'un des bits du nombre binaire. Dans chaque groupe, chaque porte OU-NON à deux entrées est connectée aux sorties Q d'une première balance et $\bar{Q}$ d'une seconde balance. Les sorties (B) des portes d'un groupe (101 à 107) (111 à 113) sont adressées sur les entrées ($\varepsilon$B) d'une porte du troisième étage (141 à 143). Le bit de poids le plus élevé (N) est obtenu directement par la sortie

$$Q_{2^N-1}.$$

de la balance de rang $2^N-1$.

Application aux chaines de traitement de l'information.

FIG_2

EP 0 249 538 A1

Bundesdruckerei Berlin

**Description**

## ENCODEUR ANALOGIQUE-NUMERIQUE

La présente invention concerne un encodeur binaire, dont la structure, ou organisation interne, permet de simplifier et de diminuer le nombre d'opérateurs logiques. L'encodeur binaire selon l'invention est un circuit qui transforme une échelle dite "thermométrique" en un nombre binaire, et il est appliqué notamment aux convertisseurs analogique-numérique.

Les encodeurs binaires sont des circuits bien connus, et ils interviennent dans tous les systèmes de conversion d'un signal analogique en un nombre binaire. Généralement, il comporte une première pluralité de portes OU-NON qui travaillent en parallèle, et dont les signaux de sortie sont adressés à une deuxième pluralité de portes OU-NON montées également en parallèle entre elles. Toutes les portes de la première série ont la même fonction, et le classement des signaux logiques, en bits depuis celui qui a le plus faible poids jusqu'à celui qui a le poids le plus élevé, se fait par le cablage entre les sorties des premières portes et les entrées multiples des secondes portes. Un nombre binaire est recueilli sur les sorties d'inverseurs montés en série avec les secondes portes.

Cette organisation d'opérateurs en série parait simple dans son fondement, mais est en fait assez complexe dans sa réalisation, car elle requiert un grand nombre de portes OU-NON dont celles de la seconde série sont d'autant plus complexes que le nombre binaire comporte un plus grand nombre de bits, et toutes ces portes OU-NON de la seconde série sont identiques entre elles. A titre d'exemple, pour exprimer un nombre avec 4 bits, il faut 4 portes OU-NON dans la seconde série, ayant chacune 8 entrées. Cela signifie que pour réaliser un encodeur en circuit intégré, il faut un nombre de transistors qui devient vite très élevé si le signal analogique doit être encodé avec précision : 1540 transistors pour 8 bits.

L'encodeur selon l'invention conserve l'utilisation de comparateurs montés en parallèle, pour "peser" le signal analogique, mais l'organisation des portes OU-NON est pyramidale, de sorte que le nombre de portes dans la pyramide est inversement proportionnel au poids représenté par les portes considérées : en conséquence le poids le plus élevé n'est représenté que par une seule sortie -sans nécessiter une porte OU-NON, le poids qui lui est inférieur est représenté par une porte à 2 entrées, et ainsi de suite.

Cette simplification des portes OU-NON de la deuxième série est dûe à l'organisation en groupes des portes de la première série. A partir des signaux de sorties d'un premier étage de comparateurs, ou balances à poids étalonné, par lequel commence toute conversion analogique-numérique, les portes OU-NON du premier groupe fournissent les informations qui permettent d'élaborer le bit de poids le plus faible. Un second groupe de portes OU-NON, travaillant en parallèle avec le premier groupe, mais connectées sur d'autres sorties de balances, fournit les informations qui permettent d'élaborer le second bit. Pour un nombre à N bits, il y a ainsi N-1 groupes de portes OU-NON, le Nième bit, de poids le plus élevé, étant obtenu directement à partir d'une sortie d'une balance, dont le numéro d'ordre est 2N-1.

Ainsi, l'invention concerne un encodeur analogique-numérique, transformant un signal électrique analogique en un nombre binaire à N bits, comprenant :
- un premier étage de 2N-1 comparateurs ou balances à poids étalonnés, qui reçoivent en parallèle le signal analogique et délivrent sur leurs sorties $Q$ et $\bar{Q}$ des valeurs logiques,
- un deuxième étage de portes OU-NON inverseuses à deux entrées, branchées, pour chaque porte, à une sortie $Q$ d'une première balance et à une sortie $\bar{Q}$ d'une seconde balance,
- un troisième étage de portes OU-NON inverseuses, à nombre variable d'entrées, branchées sur les sorties des portes du deuxième étage,
- un quatrième étage d'inverseurs branchés sur les sorties des portes du troisième étage, qui délivrent sur leurs sorties les bits constitutifs du nombre binaire,
cet encodeur analogique étant caractérisé en ce que les portes du second étage sont organisées en N groupes de portes, lesdits groupes travaillant en parallèle,
- chaque groupe de porte élaborant un bit du nombre binaire, ledit bit étant obtenu par la somme des signaux de sorties des portes dudit groupe,
- dans chaque groupe, les entrées de chaque porte sont branchées sur les sorties $Q$ d'une première balance et $\bar{Q}$ d'une seconde balance selon l'équation logique :

$$B_{2^{N'-1}(2i+1)}^{N'-1} = Q_{2^{N'-1}(2i+2)} + \bar{Q}_{2^{N'-1}(2i+1)}$$

dans laquelle :
- N' exprime l'ordre du bit, selon les poids croissants,
- i+1 exprime l'ordre d'une sortie B, selon les poids croissants dans un groupe de portes.

L'invention sera mieux comprise par la description qui va en être faite, et son organisation structurelle ressortira plus facilement en se reportant aux figures jointes en annexe, qui représentent :
- figure 1 : schéma de câblage d'un encodeur selon l'art connu,
- figure 2 : schéma de câblage d'un encodeur selon l'invention.

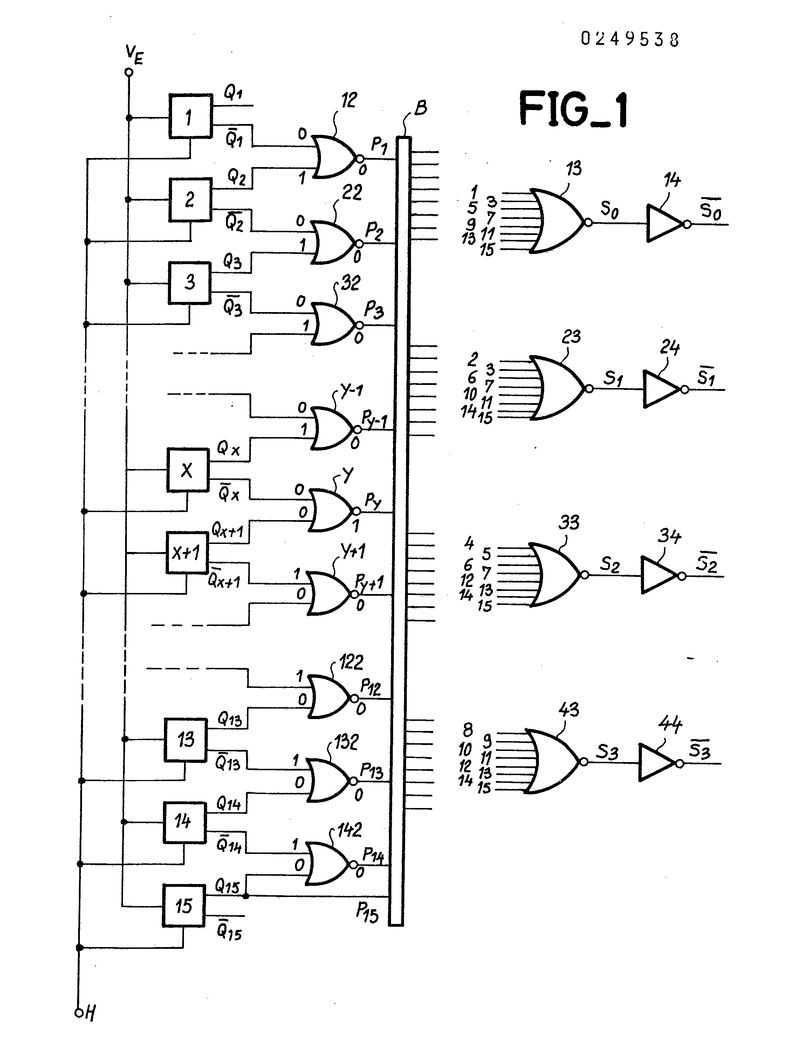

La structure de l'encodeur selon l'invention apparaîtra mieux par comparaison avec celle d'un encodeur connu telle que celle qui est donnée en figure 1.

Un tel encodeur est décrit dans la demande de brevet français No 85.16933 déposée le 15 novembre 1985 par la Demanderesse.

Un encodeur pour convertisseur analogique-numérique comporte, de façon connue, au moins quatre étages de circuits montés en série, les circuits étant en parallèle dans chaque étage. L'exemple de la figure 1 représente un encodeur à 4 bits.

Le premier étage est constitué par une série de comparateurs, ou balances à poids étalonné 1 à 15, dont chacune reçoit, en entrées parallèles, un signal d'entrée $V_E$, analogique, et un signal d'horloge H. Cette série de balances constitue ce que l'on désigne souvent sous le nom d'échelle de thermomètre : en effet, si on appelle x le rang d'une balance dans cette échelle, toutes les balances pour lesquelles le niveau de signal d'entrée est supérieur au poids étalonné d'une balance ont des sorties Q=0 logique et $\bar{Q}$=1 logique, jusqu'à la balance de rang x. Toutes les balances pour lesquelles le niveau de signal d'entrée est inférieur au poids étalonné d'une balance ont des sorties Q=1 logique et $\bar{Q}$=0 logique, à partir de la balance de rang x. Les niveaux de sorties évoquent donc une échelle thermométrique : sorties Q toutes à 0 logique jusqu'à la balance de rang x, et toutes à 1 logique au delà.

Le nombre de balances, qui est ici de 15, est lié à la résolution du convertisseur, et au nombre de bits en sortie : il faut $2^N$-1 balances pour un signal numérisé de N bits.

Le second étage est un premier encodeur, qui transforme l'échelle de thermomètre en échelle de points. Il est constitué par une série de portes OU-NON 12 à 142. Chaque porte OU-NON a une première entrée réunie à la sortie $\bar{Q}$ d'une balance de rang x et une seconde entrée réunie à la sortie Q d'une balance de rang x+1. Pour illustrer ce fonctionnement, des niveaux de sortie 0 logique et 1 logique sont représentés sur la figure 1, à titre d'exemple. Seule la porte OU-NON de rang y, qui reçoit deux signaux 0 logique sur ses deux entrées, délivre un signal 1 logique sur sa sortie. Toutes les autres portes, de rang inférieur à y ou supérieur à y, qui reçoivent des 0 et des 1 logiques, délivrent un signal 0 logique sur leur sortie.

La sortie $\bar{Q}_{15}$ de la dernière balance 15 est seule : pour être adressée à l'étage suivant, il faut l'inverser, puisque chaque porte OU-NON 12 à 142 est en fait un inverseur. Plutôt que d'inverser $\bar{Q}_{15}$, il est plus économique en nombre de transistors et en surface de circuit intégré, de prendre directement la sortie $Q_{15}$, qui est l'inverse de $\bar{Q}_{15}$.

Le troisième étage est un second encodeur, qui transforme l'échelle de points en un nombre binaire. Il est constitué d'autant de portes OU-NON 13, 23, 33 et 43 que de bits de résolution pour mesurer le signal d'entrée $V_E$ : dans le cas illustré, N=4=4 bits. Chaque porte OU-NON 13, 23, 33 ou 43 comporte 8 d'entrées.

Le quatrième étage est constitué de N inverseurs 14, 24, 34 et 44 qui délivrent les signaux numérisés sur leurs sorties $\bar{S}$ : l'ensemble donne un nombre binaire.

Sur la figure 1, un bus B représente les 32 liaisons électriques entre les 15 sorties des portes OU-NON du deuxième étage (plus la sortie $P_{15}$ du premier étage) et les 32 entrées des portes OU-NON du troisième étage.

Dans ce schéma, toutes les portes OU-NON 12 à 142 du second étage ont la même fonction : chacune reçoit sur ses deux entrées la sortie $\bar{Q}$ d'une balance de rang x et la sortie Q d'une balance de rang x+1, mais aucune porte 12 à 142 n'est plus particulièrement affectée à l'élaboration du premier ou du second bit. L'élaboration des bits du nombre binaire se fait par le câblage entre les sorties des portes du second étage et les entrées des portes du troisième étage, selon des règles qui sortent de l'exposé de l'invention.

Ce schéma nécessite, pour un signal codé sur 4 bits :
- 14 portes OU-NON à 2 entrées pour le deuxième étage,
- 4 portes OU-NON à 8 entrées pour le troisième étage,
- 4 inverseurs pour le quatrième étage.

De façon plus générale, le nombre de transistors nécessaires pour un encodeur à N bits est :

| N bits | 2e étage | 3e étage | 4e étage | Total |
|---|---|---|---|---|
| 3 | 6x2 | 3x4 | 3 | 27 |
| 4 | 14x2 | 4x8 | 4 | 64 |
| 5 | 30x2 | 5x16 | 5 | 145 |
| 6 | 62x2 | 6x32 | 6 · | 322 |
| 7 | 126x2 | 7x64 | 7 | 707 |
| 8 | 254x2 | 8x128 | 8 | 1540 |

Le nombre de transistors nécessaires pour un encodeur croit donc très vite avec le nombre de bits, et, même si l'on tient compte de la capacité des circuits intégrés à réunir sur une même puce plusieurs milliers de transistors, l'encodeur occupe une surface trop importante, compte tenu du fait qu'un convertisseur analogique-numérique n'est qu'une partie d'un circuit intégré de traitement du signal.

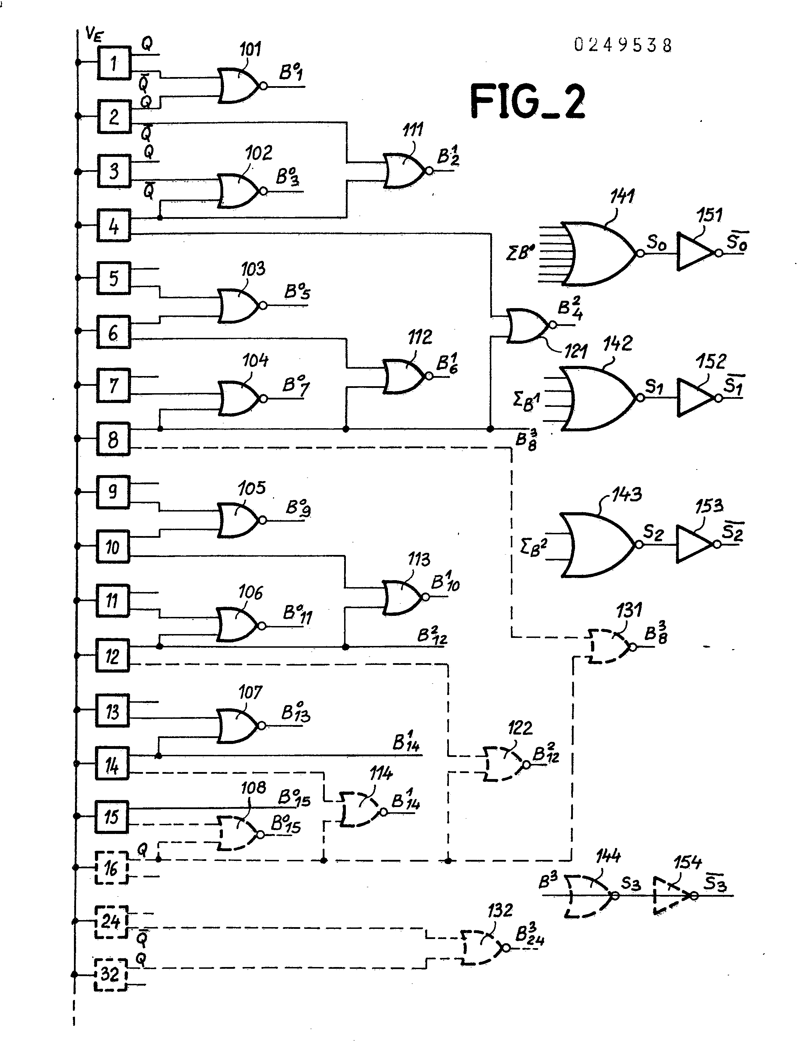

L'invention permet de réaliser un encodeur binaire nécessitant moins de transistors pour un même nombre de bits, et des portes OU-NON moins complexes pour l'étage supérieur dans son organisation pyramidale. Le schéma électrique en est donné en figure 2.

Bien entendu, ce qui n'est pas strictement nécessaire à la compréhension de l'invention n'est pas représenté sur cette figure, pour en faciliter la lecture : c'est le cas des horloges ou des tensions d'alimentations pour les comparateurs et les opérateurs OU-NON, mais l'homme de l'art est habitué à de telles simplifications.

Pour faciliter la comparaison avec l'art connu, cet encodeur est également à 4 bits, à titre d'exemple, mais on a représenté en pointillés les circuits qui interviendraient si l'encodeur était à plus de 4 bits.

Il comporte un premier étage, identique au précédent, formé par 15 comparateurs ou balances à poids étalonnés 1 à 15. Il faut $2^N - 1$ balances pour un signal numérisé sur N bits. Ces balances travaillent en parallèle : chacune a deux sorties $Q$ et $\bar{Q}$.

Les portes OU-NON qui exploitent les informations fournies par les sorties $Q$ et $\bar{Q}$ des balances 1 à 15 sont, selon l'invention, réparties en plusieurs groupes travaillant en parallèle et indépendemment les uns des autres. Chaque groupe de portes OU-NON fournit sur ses sorties les informations propres à un bit du nombre binaire : le premier groupe de portes fournit le premier bit, le second groupe de portes fournit le second bit, et ainsi de suite. L'ensemble de ces groupes de portes constitue le second étage de l'encodeur.

Les sorties $Q$ et $\bar{Q}$ du premier étage de balances 1 à 15 sont connectées sur les entrées du premier groupe de portes OU-NON inverseuses à deux entrées 101 à 107, à raison d'une porte OU-NON (101) pour deux balances (1 et 2). Il y a donc $\frac{2^N}{2} - 1$ portes 101 à 107 pour ce premier groupe, la dernière balance (15) n'étant pas réunie à une porte OU-NON, puisque sa seule sortie $Q_{15}$ est utilisée. En fait, on peut soit utiliser la sortie $\bar{Q}_{15}$ suivie d'un inverseur, puisque les portes OU-NON 101 à 107 inversent le signal, soit utiliser directement la sortie $Q_{15}$ qui est l'inverse de $\bar{Q}_{15}$.

La connexion de deux balances sur une porte OU-NON obéit à la loi suivante : les balances sont groupées deux par deux, voisines, (1+2, 3+4, 5+6 etc...) et la sortie $\bar{Q}$ de la première ainsi que la sortie $Q$ de la seconde -en suivant l'ordre des poids croissants- sont connectées aux deux entrées d'une porte OU-NON (101, 102, 103 etc...). Si l'on appele $B^0_{2\,i+1}$ le signal de sortie d'une porte OU-NON du premier groupe, on a les équations logiques :

4

$$B_1^0 = \overline{Q_2 + \bar{Q}_1}$$

$$B_3^0 = \overline{Q_4 + \bar{Q}_3}$$

et plus généralement

$$B_{2i+1}^0 = \overline{Q_{2i+2} + \bar{Q}_{2i+1}}$$

et pour la dernière

$$B_{15}^0 = \dot{Q}_{15} \text{ ou } \bar{Q}_{15}$$

puisque le nombre 2N-1 de balances est impair.

Les signaux de sortie $B_1^0$ à $B_{13}^0$ des portes 101 à 107 de ce premier groupe plus le signal $B_{15}^0$ sont adressés directement sur les huit entrées ($B^0$) d'une porte OU-NON 141 du troisième étage de l'encodeur, dont le quatrième étage est un inverseur 151, qui délivre sur sa sortie $S_0$ le bit de plus faible poids.

Le second groupe de portes OU-NON, dans ce second étage de l'encodeur, est constitué par les portes 111, 112, 113 à deux entrées, qui sont connectées aux sorties Q et $\bar{Q}$ des balances 1 à 15 du premier étage de la façon suivante. Si l'on considère l'ordre des balances numérotées selon un poids croissant de 1 à 15 -ou plus généralement de 1 à 2N-1-les balances dont les sorties $\bar{Q}$ et Q sont conectées aux entrées des portes 111 à 113 du deuxième groupe de l'encodeur ont un numéro d'ordre qui est le double du numéro d'ordre des balances connectées aux portes 101 à 107 du premier groupe.

Pour obtenir les sorties $B_1^0$ à $B_{15}^0$ du premier groupe de l'encodeur, on avait assemblé les sorties :

$$\bar{Q}_1 + Q_2 \quad \bar{Q}_3 + Q_4 \quad \bar{Q}_5 + Q_6 \quad \bar{Q}_7 + Q_8 \text{ etc...}$$

Pour obtenir les sorties $B_2^1$ à $B_{10}^1$ du deuxième groupe de l'encodeur, on assemble les sorties :

$$\bar{Q}_2 + Q_4 \quad \bar{Q}_6 + Q_8 \quad \bar{Q}_{10} + Q_{12} \text{ etc...}$$

Une partie de la figure 2 est représentée en pointillés : les pointillés montrent ce que serait le schéma si l'encodeur était à plus de 4 bits, c'est-à-dire à plus de 15 balances dans le premier étage. Mais puisqu'on a choisi d'exposer l'invention sur l'exemple, non limitatif, d'un encodeur à 4 bits, la sortie $\bar{Q}_{14}$ de la balance 14 est seule : comme cela a déjà été dit au sujet de la sortie $\bar{Q}_{15}$ du premier groupe, on prend $Q_{14}$ plutôt que d'inverser $\bar{Q}_{14}$.

Si on appelle $B_i^1$ le signal de sortie d'une porte OU-NON du deuxième groupe, on a les équations logiques :

$$B_2^1 = \overline{Q_4 + \bar{\bar{Q}}_2}$$

$$B_6^1 = \overline{Q_8 + \bar{Q}_6}$$

et plus généralement

$$B^1_{2(2i+1)} = \overline{\overline{Q}_{2(2i+2)} + \overline{Q}_{2(2i+1)}}$$

et pour la dernière

$$B^1_{14} = Q_{14} \text{ ou } \overline{\overline{Q}_{14}}$$

Les signaux de sortie $B^1_2$ à $B^1_{10}$ des portes 111 à 113 de ce deuxième groupe de l'encodeur, plus le signal $B^1_{14}$, sont adressés directement sur les quatre entrées ($\varepsilon B^1$) d'une porte OU-NON 142 du troisième étage de l'encodeur, suivie d'un inverseur 152 qui délivre sur sa sortie $\overline{S}_1$ le bit de poids immédiatement supérieur au bit délivré par la sortie $\overline{S}_0$ du premier groupe de portes 101 à 107.

L'encodeur selon l'invention comporte encore un troisième groupe de portes OU-NON 121 (et 122 s'il y a plus de 4 bits) à deux entrées, qui sont connectées comme les portes OU-NON des groupes précédents à une sortie $\overline{Q}$ et à une sortie $Q$ de deux balances du premier étage, selon la règle : les indices de numérotation des sorties des balances sont multipliés par deux chaque fois qu'on passe d'un groupe de portes OU-NON au groupe suivant.

Les sorties $B^2_4$ et $B^2_{12}$ du troisième groupe de portes OU-NON sont donc connectées respectivement à $\overline{Q}_4 + Q_8$ et $\overline{Q}_{12} + Q_{16}$ ce qui donne bien, par rapport aux sorties $B^1_2$ et $B^1_6$ du second étage de portes OU-NON

$$\overline{Q}_{2\times2} + Q_{4\times2} \quad \text{et} \quad \overline{Q}_{6\times2} + Q_{8\times2}$$

ou encore :

$$B^2_{4(2i+1)} = \overline{\overline{Q}_{4(2i+2)} + \overline{Q}_{4(2i+1)}}$$

Comme il n'y a pas de balance 16 dans un encodeur à 4 bits, la dernière sortie $B^2_{12}$ de ce troisième groupe de portes OU-NON est seule : elle est prélevée après un inverseur ou, préférentiellement, sur la sortie $Q_{12}$ de la balance 12, ce qui équivaut à $\overline{\overline{Q}_{12}}$.

Les signaux de sortie $B^2_4$ et $B^2_{12}$ du troisième groupe de l'encodeur sont adressés directement sur les deux entrées ($\varepsilon B^2$) d'une porte OU-NON 143, suivie d'un inverseur 153 qui délivre sur sa sortie $\overline{S}_2$ le bit de poids immédiatement supérieur au bit délivré par la sortie $\overline{S}_1$.

La construction de la structure pyramidale se poursuit en suivant toujours la même règle. Etant donné que dans l'exemple choisi il y a 4 bits, la sortie $B^3_8$ qui fournit le bit de poids le plus élevé de l'encodeur est unique : il n'y a pas de porte OU-NON dans le troisième étage de l'encodeur et la sortie $B^3_8$ est directement prélevée en $Q_8$, sans inverseur, ou en $\overline{Q}_8$ suivi d'un inverseur.

Cette dernière sortie $B^3_8$ est également directement utilisée comme sortie $\overline{S}_3$ qui fournit le bit de poids le plus élevé. Comme elle est seule, une porte OU-NON 144 suivie d'un inverseur 154 n'est pas nécessaire: toutefois ils sont représentés en pointillés sur la figure 2, pour la logique de l'exposé de l'invention.

Mais si par exemple l'encodeur était à 5 bits, son quatrième groupe comporterait deux portes OU-NON 131 et 132 (représentées en pointillés) connectées à :
$\overline{Q}_8 + Q_{16}$ et $\overline{Q}_{24} + Q_{32}$

Dans ce cas d'encodeur à 5 bits, on aurait alors :
- une sortie $\overline{S}_4$ fournie par $Q_{16}$
- une porte OU-NON à 2 entrées, non représentée, regroupant $B^3_8$ et $B^3_{24}$
- une porte OU-NON 143 à 4 entrées, regroupant $\varepsilon\,B^2$
- une porte OU-NON 142 à 8 entrées, regroupant $\varepsilon\,B^1$
- une porte OU-NON 141 à 16 entrées, regroupant $\varepsilon\,B^0$

De façon plus générale, si on pose :
- N = nombre de bits fournis par l'encodeur
- N' = rang du bit fourni par un groupe de portes OU-NON du second étage de l'encodeur, c'est-à-dire
N' = 1 pour le premier bit fourni par le premier groupe de portes 101 à 107, sorties $B^0_1$ à $B^0_{13}$
N' = 2 ou second bit pour un encodeur ayant deux groupes de portes 101 à 107 et 111 à 113, sorties $B^0_1$ à

$B_{13}^0$ et $B_2^1$ à $B_{10}^1$ et ainsi de suite...

- i un nombre tel que i + 1 est égal au numéro d'ordre, selon les poids croissants, d'une sortie B d'une porte OU-NON dans un groupe de portes :

i = 0 correspond aux sorties $B_1^0$ , $B_2^1$ , $B_4^2$ ..., les premières de chaque groupe,

i = 1 correspond aux sorties $B_3^0$ , $B_6^1$ , $B_{12}^2$ ... les secondes de chaque groupe, et ainsi de suite...

les sorties B des portes OU-NON sont, dans chaque groupe de portes, identifiées et définies par l'équation logique

$$B_{2^{N'-1}(2i+1)}^{N'-1} = \overline{Q_{2^{N'-1}(2i+2)} + \overline{Q}_{2^{N'-1}(2i+1)}}$$

Cette équation peut être vérifiée par quelques cas d'exemples :

$N' = 1$ $N'-1 = 0$

$$B_{2^0(2i+1)}^0 = \overline{Q_{2^0(2i+2)} + \overline{Q}_{2^0(2i+1)}}$$

$i = 0$ $B_1^0 = \overline{Q_2 + \overline{Q}_1}$

$$i=5 \quad B_{11}^{0} = \overline{Q_{12} + \overline{Q}_{11}}$$

$$N' = 2 \quad N'-1 = 1$$

$$B_{2(2i+1)}^{1} = \overline{Q_{2(2i+2)} + \overline{Q}_{2(2i+1)}}$$

$$i=1 \quad B_{6}^{1} = \overline{Q_{8} + \overline{Q}_{6}}$$

$$i=3 \quad B_{14}^{1} = \overline{Q_{16} + \overline{Q}_{14}}$$

$$N'=4 \quad N'-1=3$$

$$B_{8(2i+1)}^{3} = \overline{Q_{8(2i+2)} + \overline{Q}_{8(2i+1)}}$$

$$i=0 \quad B_{8}^{3} = \overline{Q_{16} + \overline{Q}_{8}}$$

Bien entendu, la détermination de chaque bit est complétée pour chaque groupe de portes OU-NON, par la dernière sortie $B^{N'-1}$ que est directe :
- premier bit (le plus léger) : $B_{15}^{0} = Q_{15}$
- deuxième bit $B_{14}^{1} = Q_{14}$
- troisième bit $B_{12}^{2} = Q_{12}$
- quatrième bit $B_{8}^{3} = Q_{8}$

De façon plus générale, pour chaque groupe de portes OU-NON, la dernière sortie B est déterminée par :

$$B_{2^{N'-1}(2i+1)}^{N'-1} = \overline{Q}_{2^{N'-1}(2i+1)} = Q_{2^{N'-1}(2i+1)}$$

et, pour le bit de poids le plus élevé, l'unique sortie correspond à $N'=N$ et $i=0$

$$B_{2^{N-1}}^{N-1} = Q_{2^{N-1}}$$

Par ailleurs, l'organisation de l'encodeur selon l'invention montre que, pour chaque groupe de portes OU-NON, 101 à 107, 111 à 113 etc..., les portes sont directement connectées aux balances 1 à 15 du premier étage. Par exemple, les entrées de 104 sont directement connectées aux balances 7 et 8, les entrées de 112 aux balances 6 et 8, les entrées de 121 aux balances 4 et 8, et ainsi de suite. Les groupes de portes OU-NON travaillent en parallèle entre eux, chaque groupe extrayant directement de l'échelle thermométrique le bit qui lui est propre, ce qui améliore la vitesse de conversion analogique-numérique, elle-même augmentée par le fait que les sorties B des portes ont une sortance de 1.

Le tableau suivant permet, par comparaison avec celui qui a été donné au sujet d'un encodeur selon l'art connu, de considérer la diminution du nombre de transistors nécessaires pour réaliser un encodeur selon l'invention. Les nombres donnés indiquent le nombre de transistors pour obtenir les sorties B, S et $\overline{S}$.

| N bits | B | S | $\overline{S}$ | Total |
|--------|---|---|----------------|-------|
| 3 | 12 | 6 | 2 | 20 |
| 4 | 26 | 14 | 3 | 43 |
| 5 | 56 | 30 | 4 | 90 |
| 6 | 118 | 62 | 5 | 185 |
| 7 | 244 | 126 | 6 | 376 |
| 8 | 498 | 254 | 7 | 759 |
| N | $2(2^N - N + 1)$ | $2^N - 2$ | N-1 | |

La sortie $\overline{S}$ de poids le plus élevé - $\overline{S}_3$ sur la figure 2-n'intervient pas dans ce compte, puisqu'elle est directe, sans inverseur.

L'organisation d'un encodeur selon l'invention permet de diviser par 2 environ le nombre de transistors du circuit, par rapport à un encodeur classique.

Cet encodeur est préférentiellement réalisé sous forme de circuit intégré, sur silicium ou matériaux de la famille III-V tel que GaAs. En utilisant des transistors à gaz d'électrons bidimentionnel normalement bloqués, l'encodeur analogique-numérique selon l'invention fonctionne à plus de 2 GHz, pour une résolution de 5 à 6 bits. Les balances à poids étalonné 1 à 15 du premier étage de l'encodeur peuvent avantageusement être conformes à celles qui sont décrites dans la demande de brevet français No 85.16933 déjà citée.

Il est utilisé dans les chaines de traitement de l'information, pour les convertisseurs analogique-numérique dits "flash" en télécommunications.

## Revendications

1. Encodeur analogique-numérique, transformant un signal électrique analogique en un nombre binaire à N bits, comprenant :
- un premier étage de $2^{N-1}$ comparateurs (1 à 15) ou balances à poids étalonnés, qui reçoivent en parallèle le signal analogique et délivrent sur leurs sorties Q et $\overline{Q}$ des valeurs logiques (0 et 1),
- un deuxième étage de portes OU-NON (101 à 122) inverseuses à deux entrées, branchées, pour chaque porte, à une sortie Q d'une première balance et à une sortie $\overline{Q}$ d'une seconde balance,
- une troisième étage de portes OU-NON (141 à 144) inverseuses, à nombre variable d'entrées, branchées, sur les sorties (B) des portes (101 à 122) du deuxième étage,
- un quatrième étage d'inverseurs (151 à 154) branchés sur les sorties des portes (141 à 144) du troisième étage, qui délivrent sur leurs sorties ($\overline{S}_0$ à $\overline{S}_2$) les bits constitutifs du nombre binaire, cet encodeur analogique étant caractérisé en ce que les portes du second étage (101 à 122) sont organisées en N groupes de portes (101 à 108)(111 à 114)(121-122), lesdits groupes travaillant en parallèle,
- chaque groupe de porte élaborant un bit du nombre binaire, ledit bit étant obtenu par la somme ( B) des signaux de sorties (B) des portes dudit groupe,
- dans chaque groupe, les entrées de chaque porte sont branchées sur les sorties Q d'une première balance et $\overline{Q}$ d'une seconde balance selon l'équation logique.

$$B^{N'-1}_{2^{N'-1}(2i+1)} = \overline{Q_{2^{N'-1}(2i+2)} + \overline{Q}_{2^{N'-1}(2i+1)}}$$

dans laquelle :
- N' exprime l'ordre du bit, selon les poids croissants,
- i + 1 exprime l'ordre d'une sortie B, selon les poids croissants dans un groupe de portes.

2. Encodeur analogique-numérique selon la revendication 1, caractérisé en ce que, le nombre 2N-1 de balances (1 à 15) du premier étage étant impair, la dernière sortie ($B_{15}^0$, $B_{14}^1$, $B_{12}^2$, $B_8^3$) de chaque groupe de portes du second étage est seule, et est prise directement sur la sortie Q de la dernière balance (1 à 15) branchée sur chaque groupe, selon l'équation logique :

$$B^{N'-1}_{2^{N'-1}(2i+1)} = Q_{2^{N'-1}(2i+1)} = \overline{\overline{Q}}_{2^{N'-1}(2i+1)}$$

la dernière porte OU-NON (108, 114, 122, 131) étant supprimée, chaque groupe de portes étant constitué d'une pluralité de portes plus une sortie directe ($B_{15}^0$, $B_{14}^1$, $B_{12}^2$, $B_8^3$).

3. Encodeur analogique-numérique selon la revendication 2, caractérisé en ce que le bit de poids le plus élevé (N' = N) est directement donné par la sortie Q d'une balance (1 à 15) d'ordre 2N-1 :

$$B^{N-1}_{2^N-1} = Q_{2^N-1}$$

4. Encodeur analogique-numérique selon la revendication 3, caractérisé en ce que chaque porte (141 à 143) du troisième étage de l'encodeur comporte un nombre d'entrées qui correspond à la somme des sortie ($B^0$, $B^1$, $B^2$) de chaque groupe de portes (101 à 121) du second étage, le signal de sortie ($S_0$, $S_1$, $S_2$) des portes (141 à 143) du troisième étage étant défini par l'équation logique :

$$S_i = \overline{\Sigma\, \overline{B}^i}$$

le signal de sortie du bit de poids le plus élevé $S_{N-1}$ étant délivré directement par la sortie

$$Q_{2^N-1}$$

de la balance d'ordre 2N-1

5. Encodeur analogique-numérique selon la revendication 4, caractérisé en ce que le nombre d'entrées des portes (141 à 143) du troisième étage augmente selon une puissance de 2, depuis 2° pour le bit N de poids le plus élevé ($B^3$ liaison directe) jusque 2N-1 pour le bit de poids le moins élevé ($\varepsilon$ $B^0$, 141).

6. Encodeur analogique-numérique selon la revendication 3, caractérisé en ce que, pour coder sur N bits, le deuxième étage de portes OU-NON (101-121) comprend N-1 groupes de portes.

7. Encodeur analogique-numérique selon l'une quelconque des revendications précédentes, caractérisé en ce qu'il est réalisé à l'état solide, sous forme de circuit intégré sur matériau semi-conducteur.

0249538

FIG_1

FIG_2

0249538

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-3 697 978 (SINGER) <br> * Texte relatif aux figures 4,5; figures 4,5 * | 1-7 | H 03 M 1/36 |
| Y | ELECTRONIC ENGINEERING, vol. 55, no. 677, mai 1983, pages 45-50, Londres, GB; D. HARRIS: "High speed precision latching comparator" <br> * Page 50, colonne 1, lignes 13-46; figures 7-9 * | 1-7 | |
| A | US-A-4 016 555 (TYRREL) <br> * Colonne 15, ligne 29 - colonne 16, ligne 37; figure 3 * | 1-7 | |
| A | DE-B-2 248 642 (PHILIPS) <br> * Page 5, ligne 8 - page 6, ligne 8; figure * | 1,4-7 | **DOMAINES TECHNIQUES RECHERCHES (Int. Cl.4)** <br><br> H 03 M 1/00 <br> H 03 M 7/00 |
| A | DE-A-2 521 705 (COMMUNICATIONS SATELLITE CORP.) <br> * Page 11, ligne 16 - page 12, ligne 26; figure 3 * | 1 | |

Le présent rapport de recherche a été établi pour toutes les revendications

| Lieu de la recherche | Date d'achèvement de la recherche | Examinateur |
|---|---|---|
| LA HAYE | 24-08-1987 | NUSSBAUMER C.P. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503 03 82